# EUROPEAN PATENT APPLICATION

(11) **EP 4 565 012 A1**
(43) Date of publication of application: **04.06.2025**
(21) Application number: 23859012.9
(22) Date of filing: 31.07.2023
(51) Int. Cl.: H05K 1/02

(54) **PRINTED CIRCUIT BOARD, ELECTRONIC DEVICE, AND PRINTED CIRCUIT BOARD MANUFACTURING METHOD**

(30) Priority: 29.08.2022 CN 202211040198
(71) Applicant: ZTE CORPORATION, Shenzhen, Guangdong 518057 (CN)
(72) Inventor: XIE, Jian, Shenzhen, Guangdong 518057 (CN); WEI, Zhongmin, Shenzhen, Guangdong 518057 (CN); YIN, Changgang, Shenzhen, Guangdong 518057 (CN)
(74) Representative: Canzler & Bergmeier Patentanwälte Partnerschaft mbB
(86) International application number: PCT/CN2023/110102
(87) International publication number: WO 2024/045977

(57) **Abstract**

A printed circuit board, comprising a layered structure body (1) and transmission lines (2) for transmitting signals. The transmission lines (2) are located in the layered structure body (1). The layered structure body (1) comprises a first region and a second region, the first region is a region for performing inter-layer signal transmission in the layered structure body (1), and the second region is a region other than the first region; the first thickness (d1) of each transmission line (2) in the first region is less than the second thickness (d2) of the transmission line (2) in the second region, and the first thickness (d1) is less than or equal to a first preset threshold. Also provided are an electronic device and a printed circuit board manufacturing method.

## Description

### CROSS-REFERENCE TO RELATED APPLICATIONS

This application claims priority from Chinese patent application No. 202211040198.7 filed on August 29, 2022, the entirety of which is incorporated hereby by reference.

### TECHNICAL FIELD

The present disclosure relates to the technical field of printed circuits, and particularly relates to a printed circuit board, an electronic device, and a method for manufacturing a printed circuit board.

### BACKGROUND

The printed circuit board (PCB) product with a rate up to 112Gbps has already begun to be commercialized, while the product with a rate up to 224Gbps is still under development and has been confronted with a major technical problem: how to improve signal integrity (SI) performance of the system and increase the bandwidth. As an important component in the system, the printed circuit board determines the performance of the system to a great extent.

A 224Gbps chip has a smaller pin pitch between pins, leading to a corresponding smaller pitch in the ball grid array (BGA) region. The pitch of the BGA region for a 112Gbps chip is 1.0 millimeter (mm), with 3.5/3.5 mil dual lines, while the pitch of the BGA region for the 224Gbps chip is reduced to 0.6mm with dual lines. This means that, in the narrow space of 0.6mm with the thickness of the pin being still equal to 1 Ounce (OZ), 2/2mil ultra-fine differential signal lines needs to be laid out without affecting reliability of signal transmission or increasing the difficulty for manufacturing the PCB. Therefore, the technology for manufacturing pins with a 0.6mm small pitch therebetween needs to be studied.

### SUMMARY

In an aspect, an embodiment of the present disclosure provides a printed circuit board, including a layer structure body and a transmission line for transmitting signals, the transmission line is located in the layer structure body, the layer structure body includes a first region and a second region, the first region is a region for inter-layer signal transmission in the layer structure body, and the second region is a region other than the first region; and the transmission line has a first thickness in the first region and a second thickness in the second region, and the first thickness is less than the second thickness, and less than or equal to a first preset threshold.

In another aspect, an embodiment of the present disclosure further provides an electronic device, including the printed circuit board as described above.

In another aspect, an embodiment of the present disclosure further provides a method for manufacturing the printed circuit board as described above, including: forming, in a process of forming a layer structure body, a first transmission line pattern with a first thickness in a first region of the layer structure body, and forming a second transmission line pattern with a second thickness in a second region of the layer structure body, to obtain a transmission line pattern including the first transmission line pattern and the second transmission line pattern; the first region is a region for inter-layer signal transmission in the layer structure body, and the second region is a region other than the first region; and the first thickness is less than the second thickness, and less than or equal to a first preset threshold.

### BRIEF DESCRIPTION OF DRAWINGS

FIG. 1 is a schematic sectional view of a printed circuit board according to an embodiment of the present disclosure;
FIG. 2 is a top view of a first region of a printed circuit board according to an embodiment of the present disclosure;
FIG. 3 is a schematic flowchart of a method for manufacturing a printed circuit board according to an embodiment of the present disclosure;
FIG. 4 is a schematic flowchart of forming a transmission line pattern according to an embodiment of the present disclosure;
FIG. 5 is a schematic flowchart of forming a transmission line pattern according to an embodiment of the present disclosure;
FIG. 6 is a schematic comparison between insertion loss effects of a printed circuit board in the existing art and a printed circuit board according to an embodiment of the present disclosure; and
FIG. 7 is a schematic comparison between return loss effects of a printed circuit board in the existing art and a printed circuit board according to an embodiment of the present disclosure.

### DETAIL DESCRIPTION OF EMBODIMENTS

Exemplary embodiments will be described more sufficiently below with reference to the accompanying drawings, but may be embodied in different forms and the present disclosure should not be construed as limited to the embodiments set forth herein. These embodiments are provided so that the present disclosure will be more thorough and complete, and will fully convey the scope the present disclosure to those skilled in the art.

As used herein, the term "and/or" includes any and all combinations of one or more of the associated listed items.

The terminology used herein is for the purpose of describing specific embodiments only, instead of limiting the present disclosure. As used herein, the singular forms "a", "an" and "the" include the plural forms as well, unless the context clearly indicates otherwise. It will be further understood that as used herein, the terms "comprise/include" and/or "consist of ..." specify the presence of specific features, integers, steps, operations, elements, and/or components, but do not preclude the presence or addition of one or more other features, entities, steps, operations, elements, components, and/or groups thereof.

Embodiments described herein may be described with reference to plan and/or sectional views in idealized representations of the present disclosure. Accordingly, the example illustrations may be modified in accordance with the manufacturing process and/or the tolerance. Therefore, the embodiments are not limited to the embodiments shown in the drawings, but further include modifications of configurations formed based on a manufacturing process. Thus, the regions illustrated in the figures have schematic properties, and the shapes of the regions shown in the figures illustrate specific shapes of regions of elements, but are not intended to be limitative.

Unless otherwise defined, all terms (including technical and scientific terms) used herein have the same meaning as commonly understood by one of ordinary skill in the art. It will be further understood that terms, such as those defined in commonly used dictionaries, should be interpreted as having a meaning that is consistent with their meaning in the context of the existing art and the present disclosure, and will not be interpreted in an idealized or overly formal sense unless expressly so defined herein.

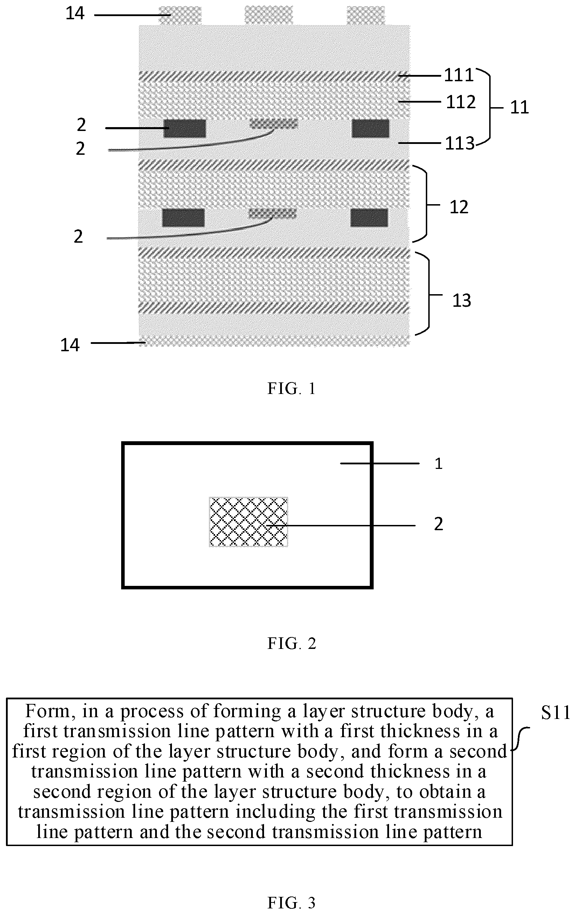

An embodiment of the present disclosure provides a printed circuit board and a method for manufacturing a printed circuit board, by locally reducing a thickness (the vertical size in a direction of up and down in FIG. 1) of a transmission line at a position corresponding to a region for inter-layer signal transmission (i.e., a region for transmitting a signal by penetrating through a layer ), thereby satisfying the small pitch expectation for manufacturing precise pins.

FIG. 1 is a schematic sectional view of a printed circuit board according to an embodiment of the present disclosure, and FIG. 2 is a top view of a printed circuit board according to an embodiment of the present disclosure. Referring to FIGs. 1 and 2, the printed circuit board according to the embodiment of the present disclosure includes a layer structure body 1 and a transmission line 2 for transmitting signals. The transmission line 2 is located in the layer structure body 1. The layer structure body 1 includes a first region and a second region. The first region is a region for inter-layer signal transmission in the layer structure body 1, and the second region is a region other than the first region. The transmission line 2 has a first thickness d1 in the first region and a second thickness d2 in the second region, and the first thickness d1 is less than the second thickness d2, and less than or equal to a first preset threshold.

The transmission line 2 may be made of metallic copper, or may be formed by etching a core board containing copper, or may be a copper wire.

The printed circuit board according to the embodiment of the present disclosure includes a layer structure body 1 and a transmission line 2 for transmitting signals. The transmission line 2 is located in the layer structure body 1. The layer structure body 1 includes a first region and a second region. The first region is a region for inter-layer signal transmission in the layer structure body 1, and the second region is a region in the layer structure body 1 other than the first region. The transmission line 2 has a first thickness d1 in the first region and a second thickness d2 in the second region, and the first thickness d1 is less than the second thickness d2, and less than or equal to a first preset threshold. According to the embodiment of the present disclosure, the transmission line 2 has different thicknesses in different regions, which can satisfy the manufacturability of pins with a relatively small pitch therebetween as well as the signal integrity expected by high-speed products, under considering both signal integrity and designability and processibility of the printed circuit board.

In some implementations, the transmission line 2 is a copper wire, and the first preset threshold is a thickness of a 0.5 ounce (OZ) copper foil (a copper foil with a thickness of 0.5OZ). In other words, the transmission line 2 has a thickness d1≤0.50Z in the first region.

In some implementations, the second thickness d2 is greater than or equal to a second preset threshold. In the case of the transmission line 2 being a copper wire, the second preset threshold is a thickness of a 1-ounce copper foil (a copper foil with a thickness of 1OZ). In other words, the transmission line 2 has a thickness d2≥1OZ in the second region.

In some implementations, the first region includes a BGA region and/or a connector region, and a metalized through hole (not shown in FIG. 1 or 2), penetrating through the layer structure body and connected to the transmission line 2, is provided in the first region. The transmission line 2 inside the PCB is led to an outer layer of the PCB through the metalized through hole to be connected to a chip pin or a connector pin or the like, thereby forming a complete signal transmission path.

The layer structure body may be of a single-layer structure, i.e., may be a single-layer PCB, or may be of a multi-layer structure, i.e., may be a multi-layer PCB. In an embodiment of the present disclosure, as shown in FIG. 1, the printed circuit board is a three-layer board, and the layer structure body 1 includes a first layer structure 11, a second layer structure 12, and a third layer structure 13 which are arranged in a stack. Each layer structure is a core board containing copper, and two transmission lines 2 are located in the first layer structure 11 and the second layer structure 12, respectively. The first layer structure 11 includes a copper layer 111, a first dielectric layer 112 and a second dielectric layer 113 which are arranged in a stacked, and the transmission line 2 is located in the second dielectric layer 113. The second layer structure 12 is identical to the first layer structure 11 in structure, and the third layer structure 13 differs from the first layer structure 11 in that there is no transmission line 2 in a second dielectric layer of the third layer structure 13. It should be noted that outer layer lines 14 are further provided on a side of the first layer structure 11 away from the second layer structure 12 and on a side of the third layer structure 13 away from the second layer structure 12. The first dielectric layer 112 and the second dielectric layer 113 are typically composed of resin, glass fibers, fillers, or the like.

From the design of the transmission line with different thicknesses in different regions, the embodiment of the present disclosure achieves the signal integrity and designability and processibility under a consideration of a relatively small pin pitch between pins.

An embodiment of the present disclosure further provides an electronic device, including the printed circuit board as described above.

An embodiment of the present disclosure further provides a method for manufacturing the printed circuit board as described above. As shown in FIG. 3, the method includes the following operation S11.

At operation S11, forming, in a process of forming a layer structure body, a first transmission line pattern with a first thickness in a first region of the layer structure body, and forming a second transmission line pattern with a second thickness in a second region of the layer structure body, to obtain a transmission line pattern including the first transmission line pattern and the second transmission line pattern.

The first region is a region for inter-layer signal transmission in the layer structure body, and the second region is a region other than the first region. The first thickness is less than the second thickness, and less than or equal to a first preset threshold.

It should be noted that, for a multi-layer PCB, after the transmission line pattern including the first transmission line pattern and the second transmission line pattern is formed, a pressing and laminating process is further performed to superpose and laminate a prepreg and the formed inner core board, thereby forming the multi-layer PCB.

In the method according to the embodiment of the present disclosure, the first thickness d1 of the transmission line 2 is made less than the second thickness d2 of the transmission line 2 by: 1. reducing an initial thickness of the transmission line 2 in the first region; or 2. increasing the initial thickness of the transmission line 2 in the second region. The following is a detailed description of these two manners.

It should be noted that, before performing the operation S11, designed PCB data is firstly created, by following operations.
1. Performing signal simulation before creating the data by electronic design automation (EDA), i.e., thin copper/thick copper is designed for a BGA region or a connector region on the PCB with a bottleneck in signal integrity.
2. Finding a region to be plated with thin/thick copper locally in the designed PCB data, the region plated with thin copper is the specified BGA region or connector region (the first region), and the region plated with thick copper is any other region (the second region).
3. Adding thin/thick copper identifiers to the above regions (first/second regions), respectively.
4. Creating Film data for copper reduction/addition, i.e., only regions for copper reduction/addition are exposed.
5. Adding a process for copper reduction/addition, and for copper reduction, a process including film lamination, exposure and copper reduction is added before etching the inner layer; and for copper addition, a process including film lamination, exposure and electroplating is added before etching the inner layer, and then normal subsequent processes including inner layer etching, browning, laminating, drilling and the like are performed.

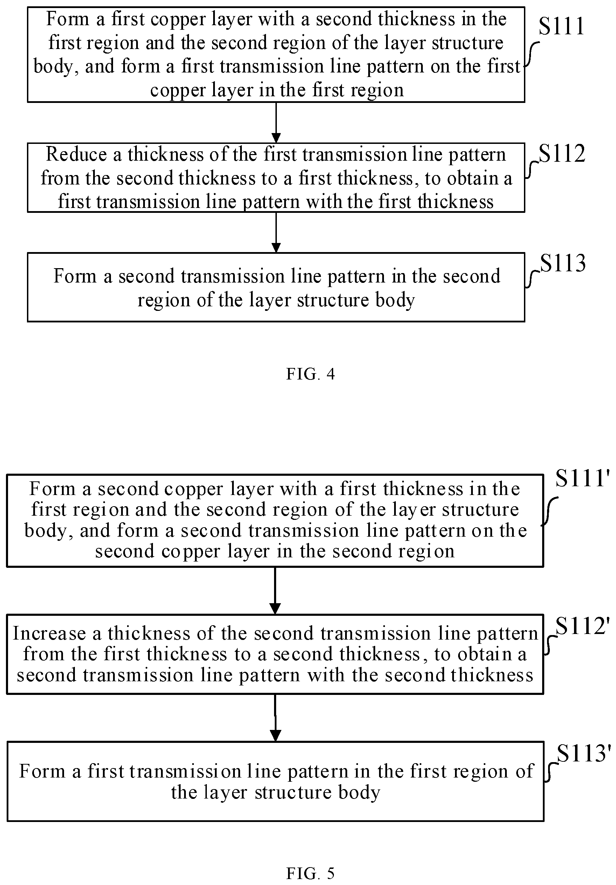

In some implementations, as shown in FIG. 4, the forming a first transmission line pattern with a first thickness in a first region of the layer structure body, and forming a second transmission line pattern with a second thickness in a second region of the layer structure body (i.e., operation S11) includes the following operations S111 to S113.

At operation S111, forming a first copper layer with a second thickness in the first region and the second region of the layer structure body, and forming a first transmission line pattern on the first copper layer in the first region.

An initial thickness of the transmission line 2 is a second thickness d2, for example, is equal to 10Z. In the operation S111, a first copper layer with the second thickness d2 is formed in the first region and the second region, and a first transmission line pattern with the second thickness d2 is formed on the first copper layer in the first region. A dry film layer (i.e., photoresist) is coated on a surface of an inner core board (a core board without forming thereon with a transferred inner layer pattern), and the inner core board coated with the dry film layer is exposed at a position thereof corresponding to the first region by a copper reduction Film on an exposure machine, to transfer a pattern for copper reduction and form a first transmission line pattern with the second thickness d2.

At operation S112, reducing a thickness of the first transmission line pattern from the second thickness to a first thickness, to obtain a first transmission line pattern with the first thickness.

In the operation S112, the thickness of the first transmission line pattern is reduced from the second thickness d2 to the first thickness d1, for example, to be 0.50Z, by a local copper reduction. The thickness of the first transmission line pattern formed on the inner core board is reduced from the second thickness d2 to the first thickness d1 by etching or the like, and then film stripping is performed to remove redundant photoresist.

At operation S113, forming a second transmission line pattern in the second region of the layer structure body.

In the operation S113, a second transmission line pattern is formed in the second region of the layer structure body, and a thickness of the second transmission line pattern is the second thickness d2. Firstly, film lamination is performed, photoresist is applied, and exposure of an inner layer is implemented in a conventional mode. Then, the inner core board, which has been subjected to the film lamination and has the transmission line 2 with copper in different thicknesses, is placed into an exposure machine including a halogen lamp for exposure, thereby completing pattern transferring. The inner core board on which exposure on lines has been completed is then etched with etching parameters being properly adjusted due to different thicknesses of the base copper, to give consideration to etch copper for both thicknesses of 0.50Z and 1OZ, thereby obtaining a second transmission line pattern.

After the processing in the operation S112, the copper on the inner core board has an un-uniform thickness, causing the film lamination to be unstable. Therefore, a vacuum film lamination process is added in the embodiment of the present disclosure to ensure the dry film layer to be laminated completely. Accordingly, in some implementations, the forming a second transmission line pattern in the second region of the layer structure body (i.e., operation S113) includes: forming a second transmission line pattern in the second region of the layer structure body through exposure, development and etching, with photoresist being attached to the second region of the layer structure body through vacuum lamination before exposure.

In some implementations, as shown in FIG. 5, the forming a first transmission line pattern with a first thickness in a first region of the layer structure body, and forming a second transmission line pattern with a second thickness in a second region of the layer structure body (i.e., operation S11) includes the following operations S111' to S113'.

At operation S111', forming a second copper layer with a first thickness in the first region and the second region of the layer structure body, and forming a second transmission line pattern on the second copper layer in the second region.

An initial thickness of the transmission line 2 is a first thickness d1, for example, 0.5OZ. In the operation S111', a second copper layer with the first thickness d1 is formed in the first region and the second region, and a second transmission line pattern with the first thickness d1 is formed on the second copper layer in the second region. A dry film layer (i.e., photoresist) is coated on a surface of an inner core board (a core board without forming thereon a transferred inner layer pattern), and the inner core board coated with the dry film layer is exposed at a position thereof corresponding to the second region by a copper addition Film on an exposure machine, to transfer a pattern for copper addition and form a second transmission line pattern with the first thickness d1.

At operation S112', increasing a thickness of the second transmission line pattern from the first thickness to a second thickness, to obtain a second transmission line pattern with the second thickness.

In the operation S112', the thickness of the second transmission line pattern is increased from the first thickness d1 to the second thickness d2, for example, to be 1OZ, by a local copper addition. The thickness of the second transmission line pattern formed on the inner core board is increased from the first thickness d1 to the second thickness d2 by electroplating or the like, and then film stripping is performed to remove redundant photoresist.

At operation S113', forming a first transmission line pattern in the first region of the layer structure body.

In the operation S113", a first transmission line pattern is formed in the first region of the layer structure body, and a thickness of the first transmission line pattern is the first thickness d1. Firstly, film lamination is performed, photoresist is applied, and exposure of an inner layer is implemented in a conventional mode. Then, the inner core board, which has been subjected to the film lamination and has the transmission line 2 with copper in different thicknesses, is placed into an exposure machine including a halogen lamp for exposure, thereby completing pattern transferring. The inner core board on which exposure on lines has been completed is then etched with etching parameters being properly adjusted due to different thicknesses of the base copper, to give consideration to etch copper for both thicknesses of 0.50Z and 1OZ, thereby obtaining a first transmission line pattern.

After the processing in the operation S112', the copper on the inner core board has an un-uniform thickness, causing the film lamination to be unstable. Therefore, a vacuum film lamination process is added in the embodiment of the present disclosure to ensure the dry film layer to be laminated completely.

Accordingly, in some implementations, the forming a first transmission line pattern in the first region of the layer structure body (i.e., operation S113') includes: forming a first transmission line pattern in the first region of the layer structure body through exposure, development and etching, with photoresist being attached to the first region of the layer structure body through vacuum lamination before exposure.

The embodiments of the present disclosure provide two manners to form the transmission line with different thicknesses in the first region and the second region, which can satisfy the manufacturability of pins with a relatively small pitch therebetween as well as the signal integrity expected by high-speed products. In a first manner, the original thickness of the copper is 1OZ, the thickness of the copper of the transmission line 2 in the first region is reduced from 1OZ to 0.50Z, and the thickness of the copper of the transmission line 2 in the second region remains unchanged, i.e., remains at the initial thickness. In a second manner, the original thickness of the copper is 0.50Z, the thickness of the copper of the transmission line 2 in the second region is increased from 0.50Z to 1OZ, and the thickness of the copper of the transmission line 2 in the first region remains unchanged, i.e., remains at the initial thickness. By reducing the thickness of the copper in the first region to 0.50Z, 2/2mil or even 1.5/1.5mil ultra-precise lines can be obtained by etching, which greatly reduces the space expected by differential lines and makes the 0.6mm pitch between pins possible.

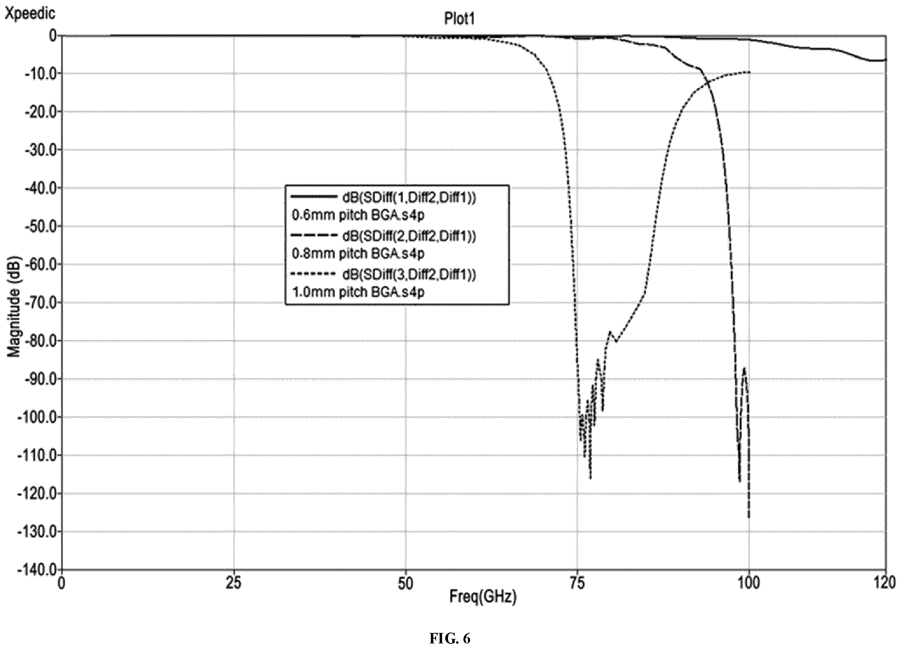

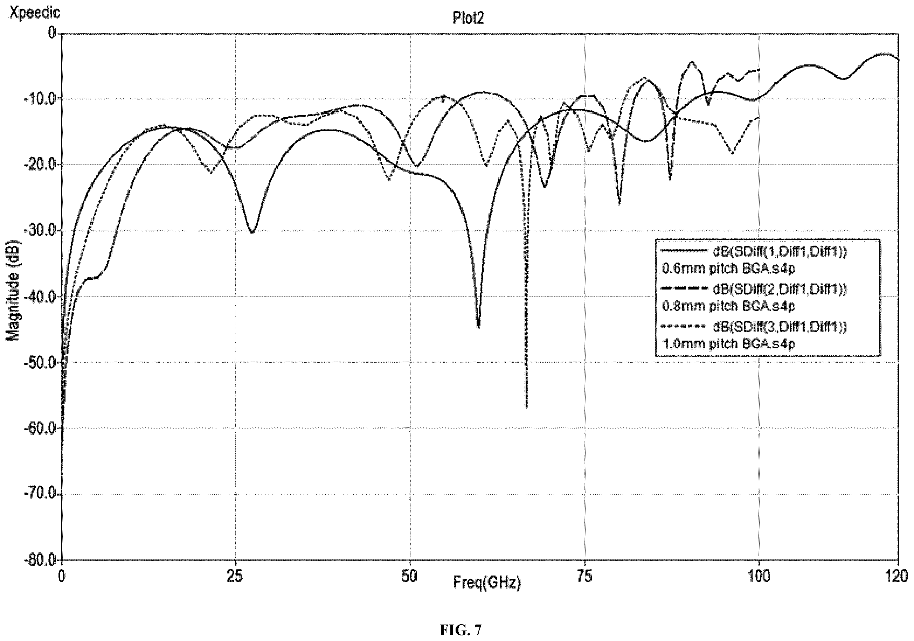

FIG. 6 is a schematic comparison between insertion loss effects of a printed circuit board in the existing art and a printed circuit board according to an embodiment of the present disclosure, and FIG. 7 is a schematic comparison between return loss effects of a printed circuit board in the existing art and a printed circuit board according to an embodiment of the present disclosure. The test experimental effects of the printed circuit boards provided in the embodiments of the present disclosure will be described below with reference to FIGs. 6 and 7.

As shown in FIG. 6, the long-dashed curve in the figure is a curve of signal insertion loss of a PCB with a 0.8mm pitch between pins in the existing art, the short-dashed curve in the figure is a curve of signal insertion loss of a PCB with a 1mm pitch between pins in the existing art, and the solid curve in the figure is a curve of signal insertion loss of a PCB with a 0.6mm pitch between pins according to an embodiment of the present disclosure, and in FIG. 6, the x-axis represents frequency and the y-axis represents insertion loss. As can be seen from FIG. 6, if the frequency reaches a certain value, the curve of signal insertion loss of the PCB with a 0.6mm pitch between pins according to the embodiment of the present disclosure is closer to 0, indicating a lower signal loss.

As shown in FIG. 7, the long-dashed curve in the figure is a curve of signal return loss of a PCB with a 0.8mm pitch between pins in the existing art, the short-dashed curve in the figure is a curve of signal return loss of a PCB with a 1mm pitch between pins in the existing art, and the solid curve in the figure is a curve of signal return loss of a PCB with a 0.6mm pitch between pins according to an embodiment of the present disclosure, and in FIG. 7, the x-axis represents frequency and the y-axis represents return loss. As can be seen from FIG. 7, if the frequency reaches a certain value, the PCBs with the 0.8mm pitch between pins and the 1mm pitch between pins in the existing art each have a signal return loss closer to 0, indicating a higher signal loss, than the PCB with the 0.6mm pitch between pins in the embodiment of the present disclosure.

The printed circuit board according to the embodiment of the present disclosure solves the problem of taking both signal integrity and designability and processibility of the metalized through hole into consideration under the expectation of high-speed transmission.

The embodiments of the present disclosure are suitable for designing high-speed printed circuit board products, especially wired and wireless products with a rate of 224Gbps or above, and may be applied to printed circuit boards with a designed rate of 224Gbps or above.

Those of ordinary skills in the art will appreciate that all or some operations of the method, functional modules/units in the apparatus described above may be implemented as software, firmware, hardware, and suitable combinations thereof. In a hardware implementation, the division between the functional modules/units mentioned in the above description does not necessarily correspond to the division of physical components; for example, one physical component may have multiple functions, or one function or operation may be performed cooperatively by several physical components. Some or all physical components may be implemented as software executed by a processor, such as a CPU, a digital signal processor or microprocessor, or implemented as hardware, or implemented as an integrated circuit, such as an application specific integrated circuit. Such software may be distributed on a computer-readable medium which may include a computer storage medium (or non-transitory medium) and a communication medium (or transitory medium). The term computer storage medium includes volatile and nonvolatile, removable and non-removable media implemented in any method or technology for storage of information such as computer-readable instructions, data structures, program modules or other data, as is well known to those of ordinary skill in the art. The computer storage medium includes, but is not limited to, an RAM, an ROM, an EEPROM, a flash or any other memory technology, a CD-ROM, a digital versatile disk (DVD) or any other optical disk storage, a magnetic cartridge, a magnetic tape, a magnetic disk storage or any other magnetic storage device, or may be any other medium used for storing the desired information and accessible by a computer. Moreover, it is well known to those ordinary skilled in the art that a communication medium typically includes a computer-readable instruction, a data structure, a program module, or other data in a modulated data signal, such as a carrier wave or other transport mechanism, and may include any information delivery medium.

The present disclosure has disclosed exemplary embodiments, and although specific terms are employed, they are used and should be interpreted merely in a generic and descriptive sense, not for purposes of limitation. In some instances, features, characteristics and/or elements described in connection with a particular embodiment may be used alone, or may be used in combination with features, characteristics and/or elements described in connection with other embodiments, unless expressly stated otherwise, as would be apparent to one skilled in the art. It will, therefore, be understood by those skilled in the art that various changes in form and details may be made without departing from the scope of the present disclosure as set forth in the appended claims.

## Claims

1. A printed circuit board, comprising a layer structure body and a transmission line for transmitting signals, wherein the transmission line is located in the layer structure body, the layer structure body comprises a first region and a second region, the first region is a region for inter-layer signal transmission in the layer structure body, and the second region is a region other than the first region; and
the transmission line has a first thickness in the first region and a second thickness in the second region, and the first thickness is less than the second thickness, and less than or equal to a first preset threshold.

2. The printed circuit board according to claim 1, wherein the transmission line is a copper wire, and the first preset threshold is a thickness of a 0.5-ounce copper foil.

3. The printed circuit board according to claim 1, wherein the second thickness is greater than or equal to a second preset threshold.

4. The printed circuit board according to claim 3, wherein the transmission line is a copper wire, and the second preset threshold is a thickness of a 1-ounce copper foil.

5. An electronic device, comprising the printed circuit board according to any one of claims 1 to 4.

6. A method for manufacturing a printed circuit board according to any one of claims 1 to 4, comprising:
forming, in a process of forming a layer structure body, a first transmission line pattern with a first thickness in a first region of the layer structure body, and forming a second transmission line pattern with a second thickness in a second region of the layer structure body, to obtain a transmission line pattern comprising the first transmission line pattern and the second transmission line pattern,
wherein the first region is a region for inter-layer signal transmission in the layer structure body, and the second region is a region other than the first region; and the first thickness is less than the second thickness, and less than or equal to a first preset threshold.

7. The method according to claim 6, wherein the forming a first transmission line pattern with a first thickness in a first region of the layer structure body, and forming a second transmission line pattern with a second thickness in a second region of the layer structure body comprises:
forming a first copper layer with a second thickness in the first region and the second region of the layer structure body, and forming a first transmission line pattern on the first copper layer in the first region;
reducing a thickness of the first transmission line pattern from the second thickness to a first thickness, to obtain a first transmission line pattern with the first thickness; and
forming a second transmission line pattern in the second region of the layer structure body.

8. The method according to claim 7, wherein the forming a second transmission line pattern in the second region of the layer structure body comprises:
forming a second transmission line pattern in the second region of the layer structure body through exposure, development and etching, wherein photoresist is attached to the second region of the layer structure body through vacuum lamination before exposure.

9. The method according to claim 6, wherein the forming a first transmission line pattern with a first thickness in a first region of the layer structure body, and forming a second transmission line pattern with a second thickness in a second region of the layer structure body comprises:
forming a second copper layer with a first thickness in the first region and the second region of the layer structure body, and forming a second transmission line pattern on the second copper layer in the second region;
increasing a thickness of the second transmission line pattern from the first thickness to a second thickness, to obtain a second transmission line pattern with the second thickness; and
forming a first transmission line pattern in the first region of the layer structure body.

10. The method according to claim 9, wherein the forming a first transmission line pattern in the first region of the layer structure body comprises:
forming a first transmission line pattern in the first region of the layer structure body through exposure, development and etching, wherein photoresist is attached to the first region of the layer structure body through vacuum lamination before exposure.
